# EUROPÄISCHE PATENTANMELDUNG

(11) **EP 4 439 091 A1**
(43) Veröffentlichungstag der Anmeldung: **02.10.2024**
(21) Anmeldenummer: 24155027.6
(22) Anmeldetag: 31.01.2024
(51) Int. Cl.: G01R 22/06, H01R 13/66, H01R 29/00, H01R 33/96, H01T 4/06

(54) **ZÄHLERSTECKKLEMME, BAUGRUPPE UND SCHALTSCHRANK**

(30) Priorität: 30.03.2023 DE 202023101631 U
(71) Anmelder: DEHN SE, 92318 Neumarkt i.d. OPf. (DE)
(72) Erfinder: Schmidkunz, Robert, 92318 Neumarkt i.d.Opf. (DE)
(74) Vertreter: Prinz & Partner mbB

(57) **Zusammenfassung**

Eine Zählersteckklemme (18) für den Einbau in einem Zählerschrank (10) ist beschrieben. Die Zählersteckklemme (18) weist wenigstens einen Eingang (22) und wenigstens einen Ausgang (24) sowie ein Gehäuse (20) auf, in dem Kontaktierungsöffnungen (38) für Kontakte (44) eines Überbrückungsgriffs (42) zum Kurzschließen des Eingangs (22) und des Ausgangs (24) vorgesehen sind. Wenigstens ein Überspannungsableiter (46) ist in dem Gehäuse (20) integriert. Die Zählersteckklemme (18) weist wenigstens einen Schutzleiteranschluss (50) für einen Schutzleiter (48) auf. Zudem sind eine Baugruppe und ein Zählerschrank (10) beschrieben.

## Beschreibung

Aus dem Stand der Technik sind Zählersteckklemmen bekannt, die typischerweise in einem Zählerschrank verbaut werden.

Grundsätzlich ist eine Zählersteckklemme zum Anschluss und zum einfachen Austausch eines Stromzählers vorgesehen, welcher beispielsweise in einem Wohngebäude montiert wird, insbesondere in dem Zählerschrank.

Die Zählersteckklemme stellt insbesondere sicher, dass der Stromzähler getauscht werden kann, ohne die Betriebsspannung von nachgeschalteten Anlagen zu unterbrechen. Dies ist möglich, da die Zählersteckklemme mehrere Kontaktierungsöffnungen hat, über die Kontakte eines speziellen Überbrückungsgriffs eingesteckt werden können, um Ein- und Abgänge der Zählersteckklemme zu überbrücken bzw. kontrolliert kurzzuschließen, sodass die nachgeschalteten Anlagen weiterhin mit Strom versorgt bleiben. Dies ermöglicht es, den Stromzähler ohne Stromunterbrechung auszutauschen.

Insofern ist sichergestellt, dass weder Störungen noch Schäden an den nachgeschalteten Anlagen auftreten, die mit einer Unterbrechung der Stromversorgung einhergingen, wenn der Stromzähler ohne Zählersteckklemme ausgetauscht werden müsste.

Zudem dient die Zählersteckklemme auch zur Erhöhung der Arbeitssicherheit, da der Austausch des Stromzählers in einfacher und vor allem sicherer Weise möglich ist.

Die Aufgabe der Erfindung ist es, eine verbesserte Zählersteckklemme bereitzustellen.

Die Aufgabe wird erfindungsgemäß gelöst durch eine Zählersteckklemme für den Einbau in einem Zählerschrank. Die Zählersteckklemme weist wenigstens einen Eingang, wenigstens einen Ausgang sowie ein Gehäuse auf, in dem Kontaktierungsöffnungen für Kontakte eines Überbrückungsgriffs zum Kurzschließen des wenigstens einen Eingangs und des wenigstens einen Ausgangs vorgesehen sind. Ferner ist wenigstens ein Überspannungsableiter in dem Gehäuse integriert. Die Zählersteckklemme weist zudem wenigstens einen Schutzleiteranschluss für einen Schutzleiter (PE-Leiter) auf.

Erfindungsgemäß ist demnach eine Überspannungsschutzfunktion in die Zählersteckklemme integriert, die über den integrierten Überspannungsableiter bereitgestellt wird, der mit dem Schutzleiter verbunden ist. Mit anderen Worten: ist der Überspannungsableiter am Schutzleiteranschluss (direkt oder indirekt) angebunden. Eine an der Zählersteckklemme anliegende Überspannung kann demnach in einfacher Weise abgeleitet werden.

Der wenigstens eine Eingang und/oder der wenigstens eine Ausgang sowie der Schutzleiteranschluss können bzw. kann als Klemme(n) ausgebildet sein, sodass es sich um eine Eingangs-, Ausgangs- bzw. Schutzleiterklemme(n) handelt.

Grundsätzlich kann die Zählersteckklemme mehrere Eingänge und Ausgänge umfassen, sodass die Zählersteckklemme für einen mehrphasigen Anschluss ausgelegt ist, beispielsweise einen dreiphasigen Anschluss. Folglich können Eingänge und Ausgänge für drei Phasenleiter (L1, L2, L3) vorgesehen sein sowie ein Anschluss für den Neutralleiter.

Demnach kann die Zählersteckklemme mehrere Eingangsklemmen für die Phasenleiter und sowie mehrere Ausgangsklemmen für die Phasenleiter und entsprechende Klemmen für den Neutralleiter neben dem wenigstens einen Schutzleiteranschluss umfassen.

Die Zählersteckklemme kann aber auch nur für einen einphasigen Anschluss ausgebildet sein.

Wie eingangs bereits erläutert, ermöglicht die Zählersteckklemme grundsätzlich, dass eine nachgeschaltete Anlage weiter mit Strom versorgt werden kann, wodurch Störungen oder Schäden durch eine Spannungsunterbrechung nicht auftreten, die ansonsten beim Tausch des Stromzählers einhergingen. Insofern ist es nicht notwendig, dass nachgeschaltete elektronische Geräte neu programmiert werden müssen, da sie nicht von der Spannungsversorgung genommen wurden.

Zudem ist auch während des Austauschs ein Überspannungsschutz gewährleistet, der nicht gegeben wäre, sofern der Überspannungsschutz im Stromzähler integriert wäre, welcher getauscht und aufgrund des gesteckten Überbrückungsgriffs nicht mehr Teil des Stromkreises ist.

Darüber hinaus stellt die erfindungsgemäße Zählersteckklemme mit dem integrierten Schutzleiteranschluss sicher, dass eine Ableitung nicht gegen den Neutralleiter erfolgt. Der Schutzleiter stellt eine Erdung der Zählersteckklemme sicher, insbesondere der Komponenten der Zählersteckklemme. Mit anderen Worten: erfolgt eine Erdung über den Schutzleiter, wodurch die Überspannungssicherheit bzw. grundsätzlich die Schutzfunktionalität hoch ist.

Ein Aspekt sieht vor, dass der wenigstens eine Eingang und der wenigstens eine Ausgang an einer gemeinsamen Außenseite des Gehäuses vorgesehen sind. Zunächst sind der wenigstens eine Eingang und der wenigstens eine Ausgang an der äußeren Oberfläche des Gehäuses der Zählersteckklemme vorgesehen, sodass der Eingang und der Ausgang von außen kontaktiert werden können. Die Handhabbarkeit der Zählersteckklemme ist dadurch verbessert, dass der wenigstens eine Eingang und der wenigstens eine Ausgang an der gemeinsamen Außenseite des Gehäuses vorgesehen sind, sodass beide in gleicher Weise zugänglich sind. Hierdurch erleichtert sich die Installation, insbesondere im Zählerschrank, zum Anschließen des wenigstens einen Eingangs und des wenigstens einen Ausgangs nur eine Seite des Gehäuses zugänglich sein muss.

Wie vorstehend bereits erläutert, kann es sich bei dem wenigstens einen Eingang und dem wenigstens einen Ausgang um Klemmen handeln, die mechanisch mit entsprechenden Eingangs- und Ausgangsleitungen gekoppelt werden, um die elektrische Verbindung herzustellen.

Darüber hinaus umfasst die Zählersteckklemme dem Stromzähler zugeordnete Anschlüsse, die jeweils leitend mit dem wenigstens einen Eingang und dem wenigstens einen Ausgang gekoppelt sind. Diese Anschlüsse werden auch als Leitungszuführung und Leitungsabgang bezeichnet und stellen die Anschlüsse für den Stromzähler dar. Im normalen Betriebszustand fließt der Strom also über den wenigstens einen Eingang durch die Zählersteckklemme zu der dem Eingang zugeordneten Leitungszuführung für den Stromzähler. Mit der Leitungszuführung ist eine Eingangsschnittstelle des Stromzählers gekoppelt, wohingegen eine Ausgangsschnittstelle des Stromzählers mit dem Leitungsabgang der Zählersteckklemme gekoppelt ist. Der Leitungsabgang ist mit dem Ausgang der Zählersteckklemme elektrisch leitend verbunden.

Die Anschlüsse, also die Leitungszuführung und der Leitungsabgang, sind ebenfalls an einer Außenseite des Gehäuses vorgesehen, insbesondere an einer gemeinsamen Außenseite des Gehäuses, sodass die Anschlüsse von außen zugänglich sind. Vorzugsweise ist die Außenseite, an der die Leitungszuführung und der Leitungsabgang vorgesehen sind, entgegengesetzt zur Außenseite, an der der Eingang und der Ausgang vorgesehen sind. Hierdurch wird der Einbau der Zählersteckklemme weiter vereinfacht.

Ein weiterer Aspekt sieht vor, dass die Zählersteckklemme eine Abdeckung aufweist, die im abgedeckten Zustand zumindest die Kontaktierungsöffnungen und/oder den Überspannungsableiter abdeckt. Hierdurch ist ein Berührungsschutz gegeben, sodass weder die Kontaktierungsöffnungen noch der Überspannungsableiter durch Unbefugte berührt werden können. Die Abdeckung kann mit einer Sicherung versehen sein, beispielsweise einer Plombe, wodurch sichergestellt ist, dass ein Öffnen der Abdeckung mutwillig vorgenommen werden muss.

Gemäß einem Aspekt ist der Überspannungsableiter in einem Ableiterbereich innerhalb des Gehäuses angeordnet, wobei der Ableiterbereich von einem Anschlussbereich separiert ist, in dem Leiter angeordnet sind, die über die Kontaktierungsöffnungen zugänglich sind. Die Leiter sind zwischen dem Eingang und der zugeordneten Leitungszuführung sowie dem Ausgang und dem zugeordneten Leitungsabgang vorgesehen, um diese entsprechend elektrisch miteinander zu verbinden. Über die entsprechenden Kontaktierungsöffnungen ist es möglich, mit dem Überbrückungsgriff die Leiter kurzzuschließen, also den Eingang und den Ausgang entsprechend zu überbrücken.

Der Überspannungsableiter ist in dem separat ausgebildeten Ableiterbereich angeordnet, der auch als ein Ableitermagazin bezeichnet werden kann. Der Ableiterbereich kann als ein beweglicher Teil des Gehäuses ausgebildet sein, wodurch ein Austausch des Überspannungsableiters in einfacher Weise möglich ist, beispielsweise durch ein Schwenken des Ableiterbereichs relativ zum Anschlussbereich.

Ebenso kann vorgesehen sein, dass die Abdeckung mehrteilig ausgebildet ist, sodass ein erstes Abdeckungsteil den Ableiterbereich abdeckt, wohingegen ein zweites Abdeckungsteil den Anschlussbereich abdeckt. Für die unterschiedlichen Abdeckungsteile können verschiedene Sicherheitsmechanismen vorgesehen sein, wodurch sichergestellt ist, dass der Ableiterbereich und der Anschlussbereich in anderer Weise zugänglich sind.

Ein weiterer Aspekt sieht ein Anzeigeelement vor, das eingerichtet ist, den Zustand des Überspannungsableiters anzuzeigen. Über das Anzeigeelement ist es somit in einfacher Weise möglich, den aktuellen Zustand des Überspannungsableiters direkt an der Zählersteckklemme festzustellen. Es muss hierzu kein Test oder eine Messung durchgeführt werden. Das Anzeigeelement kann ein (mechanischer) Indikator sein, der angibt, ob der Überspannungsableiter noch funktional ist oder nicht. Beispielsweise ist eine Anzeige vorgesehen, insbesondere eine Rot/Grün-Anzeige, über die der Zustand des Überspannungsableiters angezeigt wird.

Alternativ kann die Zählersteckklemme Teil einer Baugruppe sein, die auch den Überbrückungsgriff umfasst. Der Überbrückungsgriff kann ein Anzeigeelement aufweisen, welches als Indikator dient. Mit Hilfe des Überbrückungsgriffs kann somit im eingesetzten Zustand erfasst werden, ob der in der Zählersteckklemme integrierte Überspannungsableiter noch funktional ist oder nicht.

Grundsätzlich kann das Anzeigeelement auch eine Leuchte oder eine LED sein, die den Zustand des Überspannungsableiters entsprechend signalisiert.

Gemäß einem weiteren Aspekt umfasst die Zählersteckklemme eine Fernmeldeeinrichtung. Die Fernmeldeeinrichtung ist vorgesehen, ein elektrisches Signal auszugeben, wodurch der Zustand der Zählersteckklemme an einem entfernten Ort überwacht werden kann. Beispielsweise wird über die Fernmeldeeinrichtung der Zustand des Überspannungsableiters übermittelt.

Es kann auch vorgesehen sein, dass die Fernmeldeeinrichtung ein Signal ausgibt, sofern der Überbrückungsgriff in die Kontaktierungsöffnungen der Zählersteckklemme eingesteckt ist, insbesondere über die entsprechenden Kontakte des Überbrückungsgriffs, also der Eingang und der Ausgang überbrückt worden sind.

Ferner kann der wenigstens eine Eingang oder der wenigstens eine Ausgang als eine Push-In Klemme ausgebildet sein. Grundsätzlich können auch der Eingang und der Ausgang jeweils als Push-In Klemmen ausgebildet sein. Hierdurch ist es in einfacher Weise möglich, die entsprechenden Leitungen, insbesondere die Phasenleiter, an die Zählersteckklemme anzuschließen, da diese lediglich eingesteckt werden müssen. Auch der Anschluss für den Neutralleiter kann durch eine Push-In Klemme ausgebildet sein.

Alternativ zur Push-In-Klemme kann auch eine Klemmschraube vorgesehen sein, über die die jeweilige Leitung geklemmt wird, wenn die Schraube angezogen wird.

Gemäß einer Ausführungsform ist der wenigstens eine Überspannungsableiter ein Gasableiter. Der Gasableiter dient insbesondere dem Schutz vor Überspannungsimpulsen.

Eine weitere Ausführungsform sieht vor, dass der wenigstens eine Überspannungsableiter eine Funkenstrecke umfasst. Hierbei kann es sich um eine gasgefüllte Funkenstrecke handeln.

Ferner kann der wenigstens eine Überspannungsableiter als ein Kombi-Ableiter ausgebildet sein, der mehrere Schutzfunktionen gleichzeitig bereitstellt, beispielsweise ein Folgestromlöschvermögen. Hierdurch ist eine höhere Sicherheit bzw. Schutzfunktionalität über die Zählersteckklemme gewährleistet. Bei dem Kombi-Ableiter kann es sich um einen Kombi-Ableiter auf Funkenstreckenbasis handeln.

Die Aufgabe wird ferner gelöst durch eine Baugruppe, die einen Stromzähler sowie eine Zählersteckklemme der zuvor genannten Art umfasst. Wie eingangs erläutert, dient die Zählersteckklemme typischerweise dazu, dass ein stromunterbrechungsfreier Austausch des Stromzählers möglich ist. Insofern stellen die Zählersteckklemme und der Stromzähler eine entsprechende Baugruppe dar, die zusammen in einem Zählerschrank verbaut werden.

Die Zählersteckklemme ist insbesondere separat zum Stromzähler ausgebildet, sodass zwischen dem Stromzähler und der Zählersteckklemme entsprechende Leitungen vorgesehen sind.

Alternativ kann vorgesehen sein, dass die Zählersteckklemme über ihre Anschlüsse, also der Leitungszuführung und dem Leitungsabgang, direkt mit dem separat ausgebildeten Stromzähler gekoppelt werden kann, der entsprechende Schnittstellen aufweist, über die der Stromzähler direkt mit der Zählersteckklemme gekoppelt werden kann.

Ein weiterer Aspekt sieht vor, dass der Stromzähler mit Stromzähler mit einer Leitungszuführung der Zählersteckklemme und einem Leitungsabgang der Zählersteckklemme verbunden ist. Die Zählersteckklemme befindet sich somit im Vorzählerbereich, da eine Eingangsschnittstelle des Stromzählers mit der Leitungszuführung der Zählersteckklemme verbunden ist bzw. der Stromzähler der Zählersteckklemme nachgeschaltet ist.

Darüber hinaus kann eine Abdeckung vorgesehen sein, die den Stromzähler und die Zählersteckklemme gemeinsam abdeckt. Die gemeinsame Abdeckung stellt sicher, dass ein Zugang sowohl zum Stromzähler als auch der Zählersteckklemme nicht möglich ist. Insbesondere ist die Abdeckung mit einem Sicherheitsmechanismus versehen, sodass ein unautorisierter Zugang zum Stromzähler sowie zur Zählersteckklemme verhindert ist.

Die Erfindung stellt ferner einen Zählerschrank bereit, der eine Zählersteccklemme der zuvor genannten Art oder eine Baugruppe der zuvor genannten Art aufweist. Der Zählerschrank weist zudem ein Zählerfeld zur Anbringung eines Stromzählers auf. Mit anderen Worten: ist der Stromzähler im Bereich des Zählerfelds des Zählerschranks angeordnet.

Das Zählerfeld kann mit einer Drei-Punkt-Befestigungsschnittstelle versehen sein, an der die Zählersteckklemme befestigt ist. Insofern kann eine Drei-Punkt-Befestigungsschnittstelle vorgesehen sein, um den Stromzähler sowie die Zählersteckklemme zu befestigen. Die Drei-Punkt-Befestigungsschnittstelle kann typischerweise zumindest zwei Hutschienen umfassen, die in T-Form zueinander ausgerichtet sind. Das "T" kann dabei um 180° gedreht sein, also auf dem Kopf stehen.

Alternativ kann das Zählerfeld mit einer integrierten Befestigungs- und Kontaktierungseinrichtung (BKE-I) ausgebildet sein, an der die Zählersteckklemme befestigt ist. Insofern können der Stromzähler sowie die Zählersteckklemme mittels eines Stecksystems im Bereich des Zählerfelds befestigt werden.

Weitere Vorteile und Eigenschaften der Erfindung ergeben sich aus der nachfolgenden Beschreibung und Zeichnung, auf die Bezug genommen wird. In den Zeichnungen zeigen:
- Figur 1 eine schematische Darstellung eines erfindungsgemäßen Zählerschranks mit einer erfindungsgemäßen Baugruppe, die eine erfindungsgemäße Zählersteckklemme aufweist, und
- Figur 2 eine schematische Darstellung einer erfindungsgemäßen Zählersteckklemme mit einem Überbrückungsgriff.

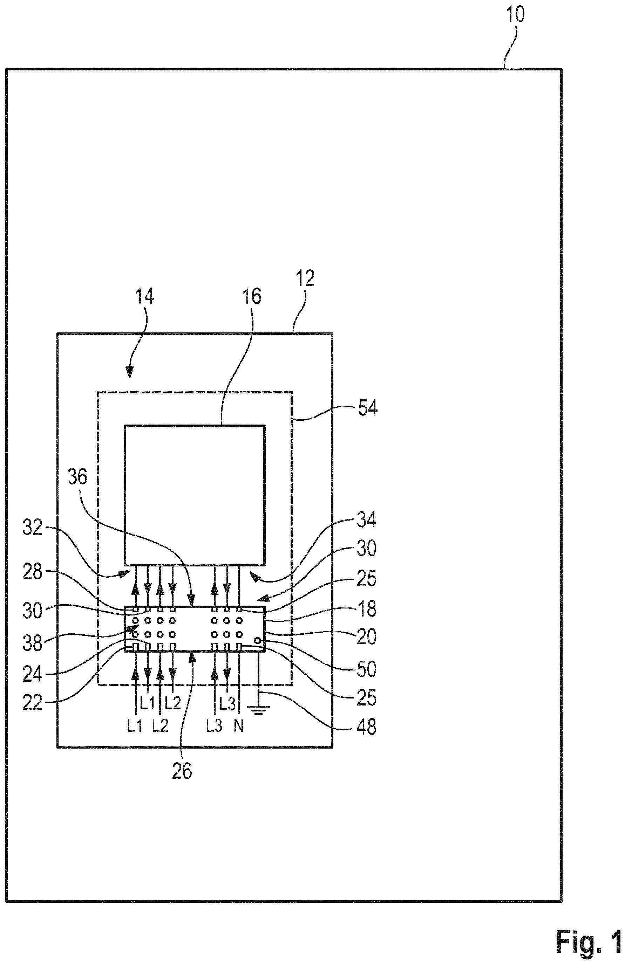

In Figur 1 ist ein Zählerschrank 10 gezeigt, der ein Zählerfeld 12 umfasst, in dem eine Baugruppe 14 angeordnet ist, die einen Stromzähler 16 sowie eine Zählersteckklemme 18 umfasst.

Der Stromzähler 16 und die Zählersteckklemme 18 sind demnach im Zählerfeld 12 befestigt.

Hierzu kann das Zählerfeld 12 eine Drei-Punkt-Befestigungsschnittstelle aufweisen, sodass beispielsweise zwei Hutschienen in T-Form zueinander angeordnet sind. Alternativ kann das Zählerfeld 12 mit einer integrierten Befestigungs- und Kontaktierungseinrichtung (BKE-I) ausgebildet sein, sodass der Stromzähler 16 und die Zählersteckklemme 18 eingesteckt sind. In beiden Alternativen ist die Baugruppe 14 in dem entsprechenden Zählerfeld 12 angeordnet.

In der gezeigten Ausführungsform hat die Zählersteckklemme 18 ein Gehäuse 20, an dem mehrere Eingänge 22 sowie mehrere Ausgänge 24 vorgesehen sind, insbesondere an einer gemeinsamen Außenseite 26 des Gehäuses 20.

Die Eingänge 22 und die Ausgänge 24 sind jeweils mit entsprechenden Leitungen verbunden, beispielsweise drei Phasenleitern L1, L2, L3, wie schematisch in Figur 1 angedeutet. Zudem sind Anschlüsse 25 für den Neutralleiter N vorgesehen.

Darüber hinaus weist die Zählersteckklemme 18 mehrere Leitungszuführungen 28 sowie mehrere Leitungsabgänge 30 auf, über die die Zählersteckklemme 18 mit dem Stromzähler 16 verbunden ist, insbesondere mit einer Eingangsschnittstelle 32 und einer Ausgangsschnittstelle 34 des Stromzählers 16.

Die mehreren Leitungszuführungen 28 und die mehreren Leitungsabgänge 30 sind ebenfalls an einer gemeinsamen Außenseite 36 angeordnet, die entgegengesetzt zur gemeinsamen Außenseite 26 ist, an der die Eingänge 22 und die Ausgänge 24 angeordnet sind. Hierdurch sind zumindest zwei Außenseiten des Gehäuses 20 anschlussfrei ausgebildet.

Darüber hinaus sind die Leitungszuführungen 28 innerhalb der Zählersteckklemme 18 mit den Eingängen 22 elektrisch verbunden und die Leitungsabgänge 30 mit den Ausgängen 24.

Dies hat zur Folge, dass der Stromfluss über die Eingänge 22 durch die Zählersteckklemme 18 zu den Leitungszuführungen 28 erfolgt, die den Eingängen 22 zugeordnet sind. Der Stromzähler 16 ist über seine Eingangsschnittstelle 32 mit den Leitungszuführungen 28 verbunden, sodass der eingehende Strom entsprechend gezählt werden kann. Die Ausgangsschnittstelle 34 des Stromzählers 16 ist mit den Leitungsabgängen 30 der Zählersteckklemme 18 gekoppelt, die mit den Ausgängen 24 der Zählersteckklemme 18 elektrisch leitend verbunden sind.

Für die Phasenleiter L1, L2, L3 sind der jeweilige Eingang 22 und der entsprechende Ausgang 24 sowie die jeweilige Leitungszuführung 28 und der entsprechende Leitungsabgang 30 jeweils paarweise angeordnet.

Die Zählersteckklemme 18 ist also im Vorzählerbereich angeordnet, sodass der Stromzähler 16 der Zählersteckklemme 18 nachgeschaltet ist.

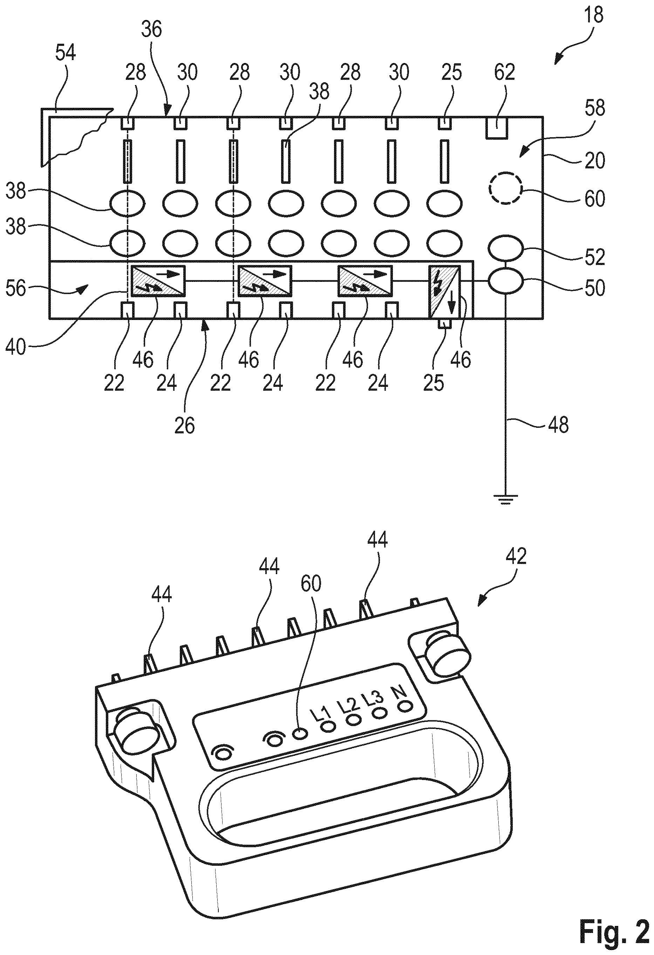

Die Zählersteckklemme 18 ist in Figur 2 detaillierter dargestellt, woraus hervorgeht, dass die Zählersteckklemme 18 zudem mehrere Kontaktierungsöffnungen 38 aufweist, die in dem Gehäuse 20 vorgesehen sind.

Die Kontaktierungsöffnungen 38 stellen einen Zugang zu im Gehäuse 20 integrierten Leitern 40 her, von denen zwei schematisch in Figur 2 gezeigt ist.

Die Leiter 40 verbinden die Eingänge 22 mit den zugeordneten Leitungszuführungen 28 sowie die Ausgänge 24 mit den zugeordneten Leitungsabgängen 30, sodass eine elektrische Verbindung über die Zählersteccklemme 18 möglich ist.

Grundsätzlich ist die Zählersteckklemme 18 vorgesehen, um mit einem Überbrückungsgriff 42 zusammenzuwirken, der Kontakte 44 aufweist, die in die Kontaktierungsöffnungen 38 der Zählersteckklemme 18 eingeführt werden können. Dies geschieht, um die Eingänge 22 und Ausgänge 24 der Zählersteckklemme 18 kurzzuschließen, wodurch ein Austausch des Stromzählers 16 beispielsweise möglich ist.

Darüber hinaus geht aus Figur 2 hervor, dass die Zählersteckklemme 18 wenigstens einen in dem Gehäuse 20 integrierten Überspannungsableiter 46 aufweist, der mit einem Schutzleiter (PE-Leiter) 48 verbunden ist. Der Überspannungsableiter 46 stellt somit einen Überspannungsschutz bereit, welcher in der Zählersteckklemme 18 integriert ist.

Bei dem Überspannungsableiter 46 kann es sich um einen Gasableiter handeln. Alternativ kann vorgesehen sein, dass der Überspannungsableiter 46 eine Funkenstrecke umfasst. Grundsätzlich kann der wenigstens eine Überspannungsableiter 46 auch als ein Kombi-Ableiter ausgebildet sein, sodass dieser gleichzeitig mehrere Schutzfunktionen bereitstellt.

Im gezeigten Ausführungsbeispiel wird deutlich, dass pro mehrere Überspannungsableiter 46 vorgesehen sind, insbesondere für jede anzuschließende Leitung, also die drei Phasenleiter L1, L2, L3 und den Neutralleiter N.

Die Zählersteckklemme 18 weist darüber hinaus wenigstens einen Schutzleiteranschluss 50 für den Schutzleiter 48 auf, womit die Überspannungsableiter 46 verbunden sind.

Zudem kann ein separat vorgesehener Schutzleiteranschluss 52 am Gehäuse 20 vorgesehen sein, der ebenfalls mit dem Schutzleiter 48 gekoppelt ist, sodass ein außenseitig zugänglicher Schutzleiterkontakt am Gehäuse 20 der Zählersteckklemme 18 ausgebildet ist.

Darüber hinaus kann die Zählersteckklemme 18 eine Abdeckung 54 aufweisen, die im abgedeckten Zustand zumindest die Kontaktierungsöffnung 38 und/oder den Überspannungsableiter 46 abdeckt. Aus Gründen der besseren Übersicht ist die Abdeckung 54 in Figur 2 nur angedeutet.

Insbesondere kann die Abdeckung 54 zwei- oder mehrteilig ausgebildet sein, sodass zumindest ein erster Abdeckungsteil und ein zweiter Abdeckungsteil vorgesehen sind. Die beiden Abdeckungsteile können unterschiedlichen Bereichen der Zählersteckklemme 18 zugeordnet sein, sodass diese Bereiche separat voneinander zugänglich sind.

Bei den entsprechenden Bereichen kann es sich um einen Ableiterbereich 56, in dem die Überspannungsableiter 46 angeordnet sind, sowie einen Anschlussbereich 58 handeln, in dem die Leiter 40 angeordnet sind. Der Ableiterbereich 56 kann vom Anschlussbereich 58 separat ausgebildet sein.

Insbesondere können die unterschiedlichen Bereiche 56, 58 derart ausgebildet sein, dass sie relativ zueinander bewegt werden können. Hierdurch ist es unter anderem möglich, den Überspannungsableiter 46 in einfacher Weise auszutauschen, indem der Ableiterbereich 56 relativ zum Anschlussbereich 58 verschwenkt wird, um die Zugänglichkeit zum Überspannungsableiter 46 zu verbessern.

Darüber hinaus kann die Zählersteckklemme 18 ein Anzeigeelement 60 aufweisen, welches den Zustand der Überspannungsableiters 46 anzeigt. Das Anzeigeelement 60 kann als eine Rot/Grün-Anzeige ausgebildet sein, wodurch der Zustand des Überspannungsableiters 46 in einfacher Weise sichtbar ist.

Alternativ oder ergänzend kann vorgesehen sein, dass der Überbrückungsgriff 42 ein entsprechendes Anzeigeelement 60 aufweist, sodass der Zustand des Überspannungsableiters 46 überprüft wird, sofern der Überbrückungsgriff 42 in die Zählersteckklemme 18 eingesteckt ist. Wie aus Figur 2 hervorgeht, kann der Überbrückungsgriff 42 zudem Anzeigen für die jeweiligen Leiter aufweisen, also die drei Phasenleiter L1, L2, L3 und den Neutralleiter N.

Das jeweilige Anzeigeelement 60 kann durch eine Leuchte ausgebildet sein, beispielsweise eine LED.

Neben dem Anzeigeelement 60, welches vor Ort sichtbar ist, kann die Zählersteckklemme 18 zudem eine Fernmeldeeinrichtung 62 umfassen, mit der der Zustand der Zählersteckklemme 18, insbesondere der Zustand der Überspannungsableiter 46, an eine separate Stelle elektrisch übermittelt wird.

Hierzu wird von der Fernmeldeeinrichtung 62 ein elektrisches Signal generiert, welches ausgesandt und entsprechend verarbeitet wird, sodass eine Information über den Zustand der Zählersteckklemme 18 an einen entfernten Ort möglich ist.

Insbesondere ist es über die Fernmeldeeinrichtung 62 auch möglich, die Information zu übermitteln, dass der Überbrückungsgriff 42 in die Zählersteccklemme 18 eingeführt worden ist, wodurch ein unsachgemäßer Gebrauch durch nichtautorisierte Personen festgestellt werden kann.

Die jeweiligen Anschlüsse der Zählersteckklemme 18, also insbesondere die Eingänge 22, die Ausgänge 24 für die Phasenleiter L1, L2, L3 sowie die Anschlüsse 25 für den Neutralleiter N und die Schutzleiteranschlüsse 50, 52, können als Push-In-Klemmen ausgebildet sein, sodass die entsprechenden Leitungen in einfacher Weise eingesteckt werden können.

Ferner kann die Abdeckung 54 zudem so ausgebildet sein, dass sie gleichzeitig die Zählersteckklemme 18 sowie den Stromzähler 16 abdeckt, wodurch ein Zugang zum Stromzähler 16 sowie zur Zählersteckklemme 18 verhindert ist. Mit anderen Worten: kann eine Abdeckung 54 für das Zählerfeld 12 vorgesehen sein.

## Patentansprüche

1. Zählersteckklemme (18) für den Einbau in einem Zählerschrank (10), wobei die Zählersteckklemme (18) wenigstens einen Eingang (22) und wenigstens einen Ausgang (24) sowie ein Gehäuse (20) aufweist, in dem Kontaktierungsöffnungen (38) für Kontakte (44) eines Überbrückungsgriffs (42) zum Kurzschließen des Eingangs (22) und des Ausgangs (24) vorgesehen sind, wobei wenigstens ein Überspannungsableiter (46) in dem Gehäuse (20) integriert ist, und wobei die Zählersteckklemme (18) wenigstens einen Schutzleiteranschluss (50) für einen Schutzleiter (48) aufweist.

2. Zählersteckklemme (18) nach Anspruch 1, **dadurch gekennzeichnet, dass** der wenigstens eine Eingang (22) und der wenigstens eine Ausgang (24) an einer gemeinsamen Außenseite (26) des Gehäuses (20) vorgesehen sind.

3. Zählersteckklemme (18) nach Anspruch 1 oder 2, **dadurch gekennzeichnet, dass** die Zählersteckklemme (18) dem Stromzähler (16) zugeordnete Anschlüsse (28, 30) aufweist, die jeweils leitend mit dem wenigstens einen Eingang (22) und dem wenigstens einen Ausgang (24) gekoppelt sind.

4. Zählersteckklemme (18) nach einem der vorhergehenden Ansprüche, **dadurch gekennzeichnet, dass** die Zählersteckklemme (18) eine Abdeckung (54) aufweist, die im abgedeckten Zustand zumindest die Kontaktierungsöffnungen (38) und/oder den Überspannungsableiter (46) abdeckt.

5. Zählersteckklemme (18) nach einem der vorhergehenden Ansprüche, **dadurch gekennzeichnet, dass** der Überspannungsableiter (46) in einem Ableiterbereich (56) innerhalb des Gehäuses (20) angeordnet ist, wobei der Ableiterbereich (56) von einem Anschlussbereich (58) separiert ist, in dem Leiter (40) angeordnet sind, die über die Kontaktierungsöffnungen (38) zugänglich sind.

6. Zählersteckklemme (18) nach einem der vorhergehenden Ansprüche, **dadurch gekennzeichnet, dass** ein Anzeigeelement (60) vorgesehen ist, das eingerichtet ist, den Zustand des Überspannungsableiters (46) anzuzeigen.

7. Zählersteckklemme (18) nach einem der vorhergehenden Ansprüche, **dadurch gekennzeichnet, dass** die Zählersteckklemme (18) eine Fernmeldeeinrichtung (62) umfasst.

8. Zählersteckklemme (18) nach einem der vorhergehenden Ansprüche, **dadurch gekennzeichnet, dass** der wenigstens eine Eingang (22) oder der wenigstens eine Ausgang (24) als eine Push-In Klemme ausgebildet ist.

9. Baugruppe (14) umfassend einen Stromzähler (16) und eine Zählersteckklemme (18) nach einem der vorhergehenden Ansprüche.

10. Baugruppe (14) nach Anspruch 9, **dadurch gekennzeichnet, dass** die Zählersteckklemme (18) separat zum Stromzähler (16) ausgebildet ist.

11. Baugruppe nach Anspruch 9 oder 10, **dadurch gekennzeichnet, dass** der Stromzähler (16) mit einer Leitungszuführung (28) der Zählersteckklemme (18) und einem Leitungsabgang (30) der Zählersteckklemme (18) verbunden ist.

12. Baugruppe (14) nach einem der Ansprüche 9 bis 11, **dadurch gekennzeichnet, dass** eine Abdeckung (54) vorgesehen ist, die den Stromzähler (16) und die Zählersteckklemme (18) gemeinsam abdeckt.

13. Zählerschrank (10) mit einer Zählersteckklemme (18) nach einem der Ansprüche 1 bis 8 oder einer Baugruppe (14) nach einem der Ansprüche 9 bis 12, wobei der Zählerschrank (10) ein Zählerfeld (12) zur Anbringung eines Stromzählers (16) aufweist.

14. Zählerschrank (10) nach Anspruch 13, **dadurch gekennzeichnet, dass** das Zählerfeld (12) mit einer 3-Punkt-Befestigungsschnittstelle versehen ist, an der die Zählersteckklemme (18) befestigt ist.

15. Zählerschrank (10) nach Anspruch 13, **dadurch gekennzeichnet, dass** das Zählerfeld (12) mit einer integrierten Befestigungs- und Kontaktierungseinrichtung (BKE-I) ausgebildet ist, in dem die Zählersteckklemme (18) befestigt ist.
